# EUROPÄISCHE PATENTANMELDUNG

(11) **EP 2 088 624 A2**
(43) Veröffentlichungstag der Anmeldung: **12.08.2009**
(21) Anmeldenummer: 09007210.9
(22) Anmeldetag: 07.04.2008
(51) Int. Cl.: H01L 27/146

(54) **Integriertes optisches Bauelement mit photonischem Kristall**

(30) Priorität: 05.04.2007 DE 102007016588; 16.04.2007 DE 102007017736; 21.05.2007 DE 102007023561
(62) Teilanmeldung aus: 08735060.9
(71) Anmelder: Fraunhofer-Gesellschaft zur Förderung der angewandten Forschung e.V., Hansastrasse 27c 80636 München (DE)
(72) Erfinder: Tschekalinskij, Wladimir, 90429 Nuernberg (DE); Junger, Stephan, 91088 Bubenreuth (DE); Weber, Norbert, 91367 Weissenohe (DE)
(74) Vertreter: Schenk, Markus

(57) **Zusammenfassung**

Ein integriertes Bauelement (10;40;50) mit einer Filterstruktur (12) mit wenigstens einem photonischen Kristall (22), der aus einem Schichtstapel aus dielektrischen Schichten (36) und einer Mehrzahl strukturierter Metallschichten (34;44) gebildet ist, wobei die strukturierten Metallschichten jeweils eine periodische Struktur aus Mikroelementen aufweisen, die gegenüber einer periodischen Struktur aus Mikroelementen einer benachbarten strukturierten Metallschicht des wenigstens einen photonischen Kristalls (22) unterschiedlich strukturiert oder lateral verschoben ist, und einem opto-elektronischen Bauteil (14), wobei die Filterstruktur (12) und das opto-elektronische Bauteil (14) gemeinsam in einem Halbleitersubstrat (16) integriert sind.

## Beschreibung

Die vorliegende Erfindung bezieht sich auf ein integriertes optisches Bauelement mit einem photonischen Kristall, das beispielsweise als Sensorelement für einen Farbsensor eingesetzt werden kann.

Eine Farbe eines Objekts ist beispielsweise ein guter Indikator zur Qualitätskontrolle bei verschiedenen Fertigungsprozessen. Um die Farbe eines Objekts festzustellen, können optische Farbsensoren verwendet werden. Optische Farbsensoren auf Basis von Silizium-Photodioden mit zusätzlichem Farbfilter für eine entsprechende spektrale Selektivität sind seit langem bekannt. Ein derartiger optischer Farbsensor umfasst mehrere getrennte Photodioden mit beschichteten Oberflächen. Die optisch wirksamen Farbschichten sind spektral selektiv, so dass nur ein entsprechender Teil eines insgesamt einfallenden elektromagnetischen Spektrums durchgelassen wird und die restlichen Spektralanteile absorbiert oder reflektiert werden.

Bildsensoren, die eine Matrix bestehend aus mehreren Millionen Pixeln aufweisen, wobei jedes Pixel wenigstens drei Photodioden umfasst, die auf ihrer lichtempfindlichen Oberfläche einen optischen Bandpass-Filter aufweisen, sind ebenfalls bekannt. Solche Bildsensoren können für Kameraanwendungen eingesetzt werden.

Optische Farbsensoren können allerdings auch ohne klassische Farbfilter aufgebaut werden. In der Schrift US 6998660 B2 wird beispielsweise ein Farbsensor beschrieben, dessen Funktionsprinzip auf einer stark wellenlängenabhängigen Absorption von Silizium beruht. In der Veröffentlichung P. B. Catrysse und B. A. Wandell, "Integrated color pixels in 0.18-µm complementary metal oxide semiconductor technology", wird ein Farbsensor auf Basis von periodisch strukturierten Metallschichten beschrieben, wobei der Farbsensor in einer CMOS-Technologie implementiert ist. Die Schrift US 7129982 B1 beschreibt einen Farbsensor, der aus einem Photodioden-Array hergestellt in CMOS-Technologie besteht, sowie aus einem sogenannten Echelon-Gitter aus einem Sol-Gelmaterial, das in einem zusätzlichen Prozessschritt aufgebracht wird. Die Oberseite des Gitters ist dabei durch eine Schutzschicht geschützt.

Soll ein optischer Farbsensor klassisch, d.h. mit Farbfilter, aufgebaut werden, so sind dazu bisher zwei Technologieschritte erforderlich. Zunächst wird eine Photodiode beispielsweise in einem CMOS-Prozess hergestellt. In einem darauffolgenden Schritt wird die Photodiode bzw. deren Oberfläche optisch beschichtet. Werden dazu Standard-Technologien verwendet, so wird eine genau definierte spektrale Filterung von einzelnen Farbkanälen erhalten, welche nicht beliebig gewählt werden können, sondern fest vorgegeben sind.

Der in der Schrift US 6998660 B2 beschriebene Farbsensor weist einen vertikalen Aufbau auf. In dieser Art realisierte Farbsensoren weisen eine relativ schlechte spektrale Trennung auf, da keine Farbfilter mit steilen Flanken realisiert werden können. Des Weiteren besteht aufgrund eines an zahlreichen Strukturen entstehenden Streulichts ein großes Übersprechen zwischen verschiedenen Farbkanälen.

Der in der Veröffentlichung "Integrated color pixels in 0.18-µm complementary metal oxide semiconductor technology" beschriebene Farbsensor weist einen Photodiodenchip auf, der mit periodisch strukturierten Metallschichten abgedeckt ist, welche stets eine gleiche Struktur aufweisen und ohne einen lateralen Versatz direkt übereinander angeordnet sind. Der beschriebene Aufbau funktioniert allerdings nur bei nahezu idealen Bedingungen zufriedenstellend. D.h., der beschriebene Farbsensor muss mit gut kollimiertem Licht bestrahlt werden, welches senkrecht zu den strukturierten Metallschichten einfällt. Außerdem muss das Licht linear polarisiert sein. Des Weiteren hat die Gitterstruktur der strukturierten Metallschicht keine fokussierende Wirkung. Daher entsteht zwischen benachbarten Photodioden Übersprechen zwischen unterschiedlichen Farbkanälen. Zwei übereinanderliegende Metallschichten bilden definitionsgemäß einen sogenannten Fabry-Perot-Resonator, welcher sehr empfindlich bezüglich der Qualität der Metalloberfläche und insbesondere des Schichtabstands ist. Dies hat zur Folge, dass eine solche Struktur sehr empfindlich hinsichtlich von Toleranzen von CMOS-Prozessen ist.

Die Schrift US 7129982 zeigt eine Photodiode mit abgeformtem Echelon-Gitter. Dieses Gitter ist eine optische Mikrostruktur und ein Aufbau solcher Strukturen ist im Rahmen eines CMOS-Prozesses mit zusätzlichen Prozessschritten möglich. Die optische Struktur muss mechanisch geschützt sein und hat ebenso wie die Gitterstrukturen der Metallschichten in der Veröffentlichung "Integrated color pixels in 0.18-µm complementary metal oxide semiconductor technology" keinen Schutz gegen Streulicht aus anderen Beugungsordnungen.

Wünschenswert wäre daher ein vollständig, d.h. ohne zusätzliche Prozessschritte, in einem herkömmlichen CMOS-Prozess herstellbares optisches Bauteil mit hoher spektraler Selektivität, das als Farbsensor bzw. als Sensorelement zur Selektion einer gewünschten elektromagnetischen Wellenlänge eingesetzt werden kann.

Die Aufgabe der vorliegenden Erfindung besteht somit darin, ein integriertes Bauteil mit verbesserter spektraler Selektivität bereitzustellen, das vollständig in CMOS-Prozessschritten hergestellt werden kann.

Diese Aufgabe wird durch ein integriertes Bauteil mit den Merkmalen des Patentanspruchs 1, ein integriertes Bauteil mit den Merkmalen des Patentanspruchs 21, ein integriertes Bauteil mit den Merkmalen des Patentanspruchs 22, ein integriertes Farbarray gemäß Anspruch 23 und ein Verfahren gemäß Patentanspruch 24 gelöst.

Der vorliegenden Erfindung liegt die Erkenntnis zugrunde, dass ein integriertes optisches Bauteil mit den gewünschten Eigenschaften realisiert werden kann, indem ein opto-elektronisches Bauteil, in Form eines Pixelsensors oder einer elektromagnetischen Strahlungsquelle, gemeinsam mit wenigstens einem photonischen Kristall bzw. einer Struktur mit Eigenschaften eines photonischen Kristalls auf einem Halbleitersubstrat integriert wird, um vorteilhafte Eigenschaften des photonischen Kristalls, wie beispielsweise eine hohe spektrale Selektivität und Fokussierwirkung auszunutzen.

Gemäß einer Ausführungsform kann das optische Bauteil als Sensorelement zum Detektieren von elektromagnetischer Strahlung eines vorbestimmten Wellenlängenbereichs ausgebildet sein. Dabei ist das opto-elektronische Bauteil als Pixelsensor, insbesondere als Fotodiode, ausgebildet.

Gemäß einer anderen Ausführungsform kann das optische Bauteil als eine elektromagnetische Strahlungsquelle zum Ausstrahlen von elektromagnetischer Strahlung eines vorbestimmten Wellenlängenbereichs ausgebildet sein. Dabei ist das opto-elektronische Bauteil als Strahlungsquelle, insbesondere als Leuchtdiode, ausgebildet.

Unter einem photonischen Kristall soll im Nachfolgenden eine dreidimensionale periodische Struktur verstanden werden, deren periodisch angeordnete Strukturelemente Abmessungen und Abstände zueinander aufweisen, die in der Größenordnung des vorbestimmten Wellenlängenbereichs der elektromagnetischen Strahlung liegen. Photonische Kristalle umfassen strukturierte Metalle, Halbleiter, Gläser oder Polymere und zwingen elektromagnetische Strahlung, insbesondere Licht, mittels ihrer spezifischen Struktur dazu, in der sich für eine Bauteilfunktion notwendigen Art und Weise im Medium auszubreiten. Es sind gemäß Ausführungsbeispielen periodisch dielektrische und/oder metallische Strukturen, deren Periodenlänge so eingestellt ist, dass sie die Ausbreitung elektromagnetischer Strahlung, insbesondere Licht, in ähnlicher Weise beeinflussen, wie das periodische Potential in Halbleiterkristallen die Ausbreitung von Elektronen. Dies führt dazu, dass sich elektromagnetische Strahlung bzw. Licht bestimmter Wellenlängen nicht im photonischen Kristall ausbreiten kann. Diese Wellenlängen sind gewissermaßen verboten. Die spektrale Filterwirkung photonischer Kristalle ist seit einigen Jahren bekannt und durch Experimente bestätigt. Beispielsweise zeigen Ergebnisse in "Air-bridged phototonic crystal slabs at visible and near-infrared wavelenghts" K.B. Crozier, Virginie Lousse, Onur Kilic, Sora Kim, Shanhui Fan, and Olav Solgaard, dass bei dreidimensional periodisch strukturierten Metallflächen nicht alle Wellenlängen gleichermaßen durch solche Strukturen hindurchtreten, wenn die Strukturen kleiner als die Wellenlänge sind. Aus der Arbeit "The Optical Properties of Metal Nanoparticles: The Influence of Size, Shape, and Dielectric Environment" K. Lance Kelly, Eduardo Coronado, Lin Lin Zhao, and George C. Schatz folgt, dass die spektralen Eigenschaften solcher periodischer Strukturen stark von der Form der einzelnen Strukturelemente abhängen. Die fokussierende Wirkung dreidimensionaler photonischer Kristalle (d.h. eine Ablenkung elektromagnetischer Strahlung vom Rand zur Mitte des photonischen Kristalls hin) wurde gezeigt in "Analysis of focusing effects of 3-D photonic crystal lens by the method of moments" Chaowei Su, Chi Hou Chan, Ka Fai Chan.

Gemäß Ausführungsbeispielen der vorliegenden Erfindung wird zusätzlich zu einem opto-elektronischen Bauteil auf einem Halbleitersubstrat wenigstens ein photonischer Kristall bzw. eine periodische Anordnung von photonischen Kristallen aus einem Schichtstapel aus strukturierten metallischen dielektrischen Schichten integriert, die ebenfalls strukturiert sein können, mit optisch filternden und fokussierenden Eigenschaften. Die strukturierten Metallschichten weisen dazu Struktur- bzw. Mikroelemente auf, deren Abmessungen und Abstände zueinander in der Größenordnung des vorbestimmten Wellenlängenbereichs liegen, für den das integrierte optische Bauteil ausgebildet ist. Die Mikroelemente der Metallschichten sind dreidimensional periodisch angeordnet. Gemäß Ausführungsbeispielen sind benachbarte Mikroelemente benachbarter Metallschichten identisch ausgebildet und liegen auf einer gemeinsamen optischen Achse. Mikroelemente können gemäß Ausführungsbeispielen Mikroöffnungen mit Abmessungen und Abständen in dem vorbestimmten Wellenlängenbereich sein. Gemäß einer Ausführungsform umfassen die Mikroelemente sogenannte Split-Ring-Resonatoren mit Abmessungen und Abständen in dem vorbestimmten Wellenlängenbereich.

Vorzugsweise umfasst der photonische Kristall eine Mehrzahl von CMOS-Metallschichten (z.B. CMOS Metall1/2/3 Schichten), in der die Mikroelemente strukturiert sind, und/oder Metallschichten, in der, neben den Mikroelementen, metallische, elektrische Verbindungen bzw. Leiterbahnen zwischen Schaltungselementen (z.B. Transistoren) des integrierten Bauelements strukturiert sind. Eine Dicke einer CMOS-Metallschicht liegt bei Ausführungsbeispielen in einem Bereich größer als oder gleich 90 nm.

Bei einem als optischer Sensor wirkenden integrierten Bauelement gemäß Ausführungsbeispielen wird eine auf einer dem Pixelsensor bzw. der Photodiode abgewandten Seite des wenigstens einen photonischen Kristalls einfallende elektromagnetische Strahlung durch die auf den vorbestimmten Wellenlängenbereich abgestimmte dreidimensionale periodische Struktur des als Filterstruktur wirkenden wenigstens einen photonischen Kristalls gefiltert, so dass in einer Nähe des Pixelsensors nur noch elektromagnetische Strahlung des vorbestimmten Wellenlängebereichs empfangbar ist. D.h. der Pixelsensor ist in einem Feldkonzentrationsbereich (quasi ein Brennpunktbereich, wenn man den photonischen Kristall als Linse betrachten würde) der Filterstruktur für die elektromagnetische Strahlung angeordnet. Durch die fokussierende Wirkung der Filterstruktur bzw. des wenigstens einen photonischen Kristalls wird in der Nähe des Pixelsensors das elektromagnetische Feld des vorbestimmten Wellenlängenbereichs konzentriert.

Bei einem als Strahlungsquelle wirkenden integrierten Bauelement gemäß Ausführungsbeispielen wird eine auf einer der Lichtquelle bzw. Leuchtdiode zugewanden Seite des wenigstens einen photonischen Kristalls einfallende elektromagnetische Strahlung der Lichtquelle durch die auf den vorbestimmten Wellenlängenbereich abgestimmte dreidimensionale periodische Struktur der Filterstruktur bzw. des wenigstens einen photonischen Kristalls gefiltert, so dass auf einer der Lichtquelle bzw. Leuchtdiode abgewandten Seite des wenigstens einen photonischen Kristalls austretende elektromagnetische Strahlung nur noch Wellenlängen des vorbestimmten Wellenlängenbereichs aufweist. Auch hier wird die Lichtquelle vorzugsweise in dem Feldkonzentrationsbereich der Filterstruktur angeordnet. In dem Fall eines Leuchtelements als elektrooptischem Bauelement kann zudem die Sub-Lambda-Zonenplattenstruktur eine positive, die Raumwinkelverteilung beeinflussende Wirkung aufweisen.

Um die spektral selektierende Wirkung eines integrierten Bauelements gemäß Ausführungsbeispielen zu verbessern, kann zwischen dem opto-elektronischen Bauteil und der Filterstruktur mit dem wenigstens einen photonischen Kristall eine Metallschicht mit einer Öffnung angeordnet werden. Dabei befindet sich der Mittelpunkt der Öffnung, welcher insbesondere eine kreisförmige Öffnung sein kann, vorzugsweise auf der optischen Achse der Filterstruktur (Mikrolinse auf Basis photonischer Kristalle) nahe dem Feldkonzentrationsbereich.

Gemäß Ausführungsbeispielen ist der Abstand zwischen dem opto-elektronischen Bauteil und der Filterstruktur kleiner als 20 µm und bevorzugt kleiner als 8 µm. Bei 0,18 µm-CMOS-Prozessen ist der Abstand zwischen dem opto-elektronischen Bauteil und der Filterstruktur kleiner als 2 µm.

Aus einer Mehrzahl von als optische Sensoren wirkenden integrierten Bauelementen gemäß Ausführungsbeispielen der vorliegenden Erfindung kann beispielsweise ein integrierter Farbsensor aufgebaut werden, indem eine Mehrzahl von Sensorelementen mit Filterstrukturen mit photonischen Kristallen und Pixelsensoren in einer Ebene benachbart zueinander integriert wird. Dabei entsteht ein Array bzw. eine Matrix aus Filterstrukturen mit photonischen Kristallen. Dabei können die photonischen Kristalle der einzelnen Sensorelemente auf unterschiedliche Wellenlängenbereiche eingestellt werden. Für einen RGB-Farbsensor (RGB = Rot Grün Blau) werden benachbarte Sensorelemente beispielsweise auf rotes, grünes und blaues Licht eingestellt. Natürlich sind auch mehr als drei unterschiedliche Farben bzw. Wellenlängenbereiche möglich.

Ein Vorteil der vorliegenden Erfindung besteht darin, dass mit integrierten Bauelementen gemäß Ausführungsbeispielen eine hohe spektrale Auflösung und steile Filterflanken erzielt werden können, da ein integriertes Bauelement gemäß Ausführungsbeispielen so ausgelegt werden kann, dass jeweils nur eine Wellenlänge bzw. durch den wenigstens einen photonischen Kristall herausgefiltert wird. Des Weiteren kann mit Ausführungsbeispielen der vorliegenden Erfindung die spektrale Filterbreite des innerhalb eines CMOS-Prozesses realisierten Filters mit wenigstens einem photonischen Kristall angepasst werden, das heißt, die spektralen Eigenschaften eines Farbkanals können nahezu frei definiert werden, und zwar nur im Rahmen der Herstellung ohne zusätzliche Prozessierung.

Ausführungsbeispiele der vorliegenden Erfindung ermöglichen eine Realisierung eines einfachen Farbsensors. Des Weiteren können farbempfindliche Pixel in einem zweidimensionalen Bildsensor realisiert werden. Dabei umfasst ein farbempfindlicher Pixel bzw. ein Superpixel beispielsweise drei Sensorelementen für unterschiedliche Wellenlängen.

Ein weiterer Vorteil der vorliegenden Erfindung besteht darin, dass für ein Funktionieren eines integrierten Bauteils gemäß Ausführungsbeispielen und die fokussierende Wirkung desselben nicht zwingend kollimiertes und/oder polarisiertes Licht erforderlich ist.

Bevorzugte Ausführungsbeispiele der vorliegenden Erfindung werden nachfolgend bezugnehmend auf die beiliegenden Zeichnungen näher erläutert. Es zeigen:
- Fig. 1: eine perspektivische Ansicht eines integrierten Bauelements mit einer Filterstruktur mit einem Array aus photonischen Kristallen und einem opto-elektronischen Bauteil gemäß einem Ausführungsbeispiel der vorliegenden Erfindung;
- Fig. 2: eine Seitenansicht eines mit CMOS-Technik gefertigten Schichtstapels aus opto-elektronischem Bauteil, Metallschichten und dielektrischen Schichten gemäß einem Ausführungsbeispiel der vorliegenden Erfindung;
- Fig. 3a: eine Seitenansicht eines Ausschnitts eines Bauelements mit wenigstens einemphotonischen Kristall gemäß einem Ausführungsbeispiel der vorliegenden Erfindung;
- Fig. 3b: eine Seitenansicht von drei benachbart integrierten Bauteilen gemäß Fig. 3a;
- Fig. 4a: eine Seitenansicht eines Ausschnitts eines Bauelements mit wenigstens einem photonischen Kristall und zusätzlicher Metallschicht mit Öffnung zwischen photonischem Kristall und Pixelsensor gemäß einem Ausführungsbeispiel der vorliegenden Erfindung;
- Fig. 4b: eine Seitenansicht von drei benachbart integrierten Bauteilen gemäß Fig. 4a;
- Fig. 5a: eine Draufsicht auf eine Metallschicht mit Split-Ring-Resonatoren gemäß einem Ausführungsbeispiel der vorliegenden Erfindung;
- Fig. 5b: eine Draufsicht auf eine Metallschicht mit Split-Ring-Resonatoren und darunter liegender Metallschicht mit Lochöffnung, gemäß einem Ausführungsbeispiel der vorliegenden Erfindung;
- Fig. 6: eine schematische Darstellung einer elektromagnetischen Feldkonzentration in einer Nähe einer mit einer Öffnung versehenen Metallschicht gemäß einem Ausführungsbeispiel der vorliegenden Erfindung;
- Fig. 7: eine schematische Seitenansicht von dreidimensionalen Mikroelementen; und
- Fig. 8: eine Draufsicht auf einen Array aus photonischen Kristallen gemäß einem Ausführungsbeispiel der vorliegenden Erfindung.

Bezüglich der nachfolgenden Beschreibung sollte beachtet werden, dass bei den unterschiedlichen Ausführungsbeispielen gleiche oder gleich wirkende Funktionselemente gleiche Bezugszeichen aufweisen und somit die Beschreibungen dieser Funktionselemente in den verschiedenen, im Nachfolgenden dargestellten, Ausführungsbeispielen untereinander austauschbar sind.

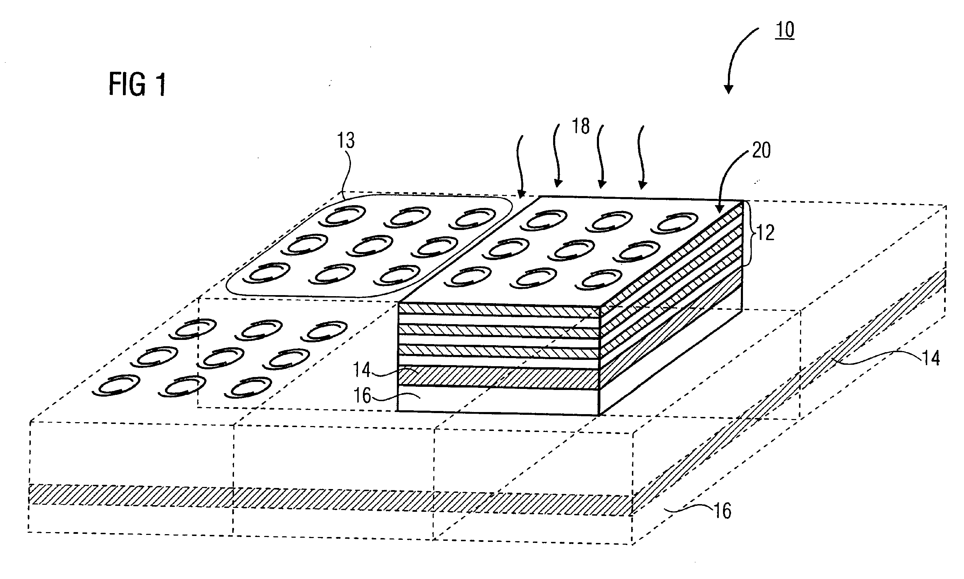

Fig. 1 zeigt eine schematische Ansicht eines integrierten Bauelements 10 zur Filterung von elektromagnetischer Strahlung eines vorbestimmten Wellenlängenbereichs, wobei zur Verdeutlichung des Aufbaus des integrierten Bauelements 10 ein Ausschnitt besonders hervorgehoben ist.

Das integrierte Bauelement 10 weist eine Filterstruktur 12 mit wenigstens einem photonischen Kristall bzw. einem Array aus photonischen Kristallen auf und ein opto-elektronisches Bauteil 14, wobei die Filterstruktur 12 und das opto-elektronische Bauteil 14 gemäß Ausführungsbeispielen derart in einem Halbleitersubstrat 16 integriert sind, so dass das opto-elektronische Bauteil 14 in einem Feldkonzentrationsbereich der Filterstruktur 12 angeordnet ist.

Wie im Vorhergehenden bereits beschrieben wurde, handelt es sich bei der Filterstruktur 12 gemäß Ausführungsbeispielen um einen photonischen Kristall bzw. um eine periodische Anordnung einer Mehrzahl von photonischen Kristallen, wobei die Filterstruktur 12 bzw. jeder der photonischen Kristalle aus einem Schichtstapel aus dielektrischen Schichten und strukturierten Metallschichten gebildet ist, worauf im Nachfolgenden noch näher eingegangen wird.

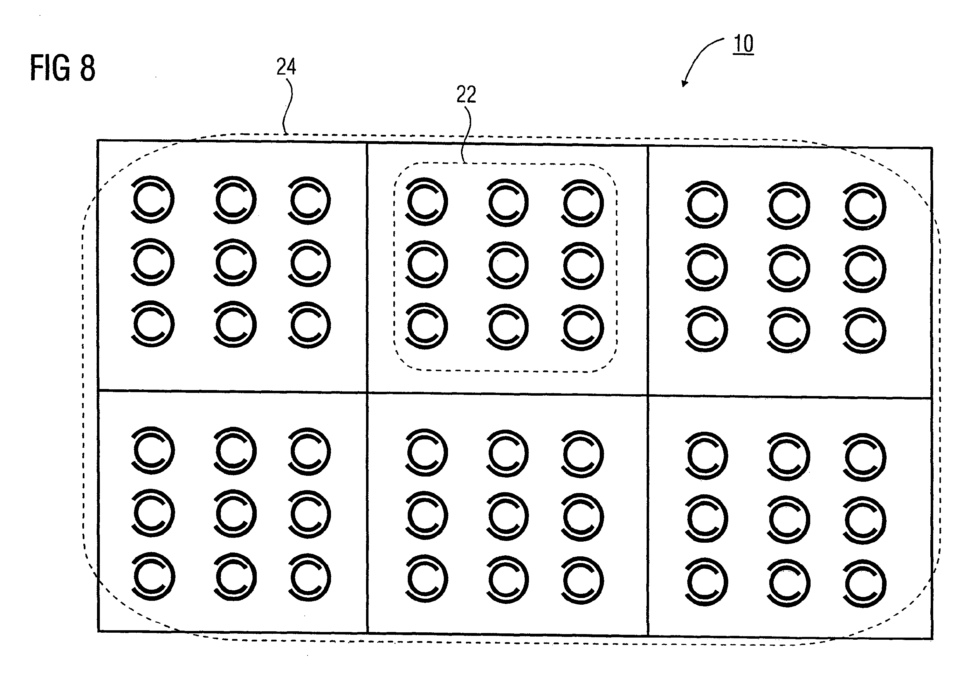

An dieser Stelle soll anhand von Fig. 8, welche eine Draufsicht auf Fig. 1 darstellt, erläutert werden, was im Folgenden unter einem photonischen Kristall bzw. einem Array aus photonischen Kristallen verstanden werden soll.

Ein einzelner photonischer Kristall der Filterstruktur 12 ist in Fig. 8 mit Bezugszeichen 22 gekennzeichnet, während die Gesamtheit der photonischen Kristalle als Array 24 bzw. periodische Anordnung von photonischen Kristallen bezeichnet werden soll. Dabei kann der Array 24 von photonischen Kristallen wiederum als ein größerer, übergeordneter photonischer Kristall betrachtet werden.

Bei Ausführungsbeispielen bewirkt die Filterstruktur 12 mit dem wenigstens einen photonischen Kristall 22 für auf einer dem opto-elektronischen Bauteil 14 abgewandten Seite 20 eintreffenden elektromagnetischen Strahlung 18 eine spektrale Selektion bzw. eine spektrale Filterung sowie eine Fokussierung elektromagnetischer Strahlung eines vordefinierten Wellenlängenbereichs in dem Feldkonzentrationsbereich, so dass nahe einer dem opto-elektronischen Bauteil 14 zugewandten Seite der Filterstruktur bzw. nahe dem opto-elektronischen Bauteil 14 für den vordefinierten Wellenlängenbereich eine elektomagnetische Feldkonzentration vorherrscht, welche von dem opto-elektronischen Bauteil 14 detektiert werden kann. Dabei handelt es sich bei Ausführungsbeispielen bei dem opto-elektronischen Bauteil 14 um ein Bauteil, das elektromagnetische Strahlung in ein elektrisches Signal umwandeln kann, wie z.B. ein PN-Übergangssensor. Dabei meint ein PN-Übergangssensor einen Sensor mit einem durch unterschiedliche Dotierung realisierten PN-Übergang. Gemäß Ausführungsbeispielen ist der PN-Übergangssensor als Photodiode ausgebildet.

Im optischen Wellenlängenbereich bedeutet dies eine spektrale Selektion einer bestimmten Wellenlänge bzw. eines vordefinierten Wellenlängenbereichs um die Wellenlänge durch den wenigstens einen photonischen Kristall 22, und eine Fokussierung des Lichts mit der vorbestimmten Wellenlänge. Welche Wellenlänge der wenigstens eine photonische Kristall 22 passieren lässt und welche Wellenlängen von ihm herausgefiltert werden, hängt von der dreidimensionalen periodischen Struktur des wenigstens einen photonischen Kristalls 22 bzw. dem Array 24 ab.

Somit können Ausführungsbeispiele der vorliegenden Erfindung beispielsweise als Sensorelement verwendet werden, um elektromagnetische Strahlung, insbesondere Licht, in dem vordefinierten Wellenlängenbereich zu detektieren.

Bei einem als Strahlungsquelle wirkenden integrierten Bauelement 10 gemäß Ausführungsbeispielen ist das opto-elektronischen Bauteil 14 ein Bauteil, das ein elektrisches Signal in elektromagnetische Strahlung, insbesondere Licht, umwandeln kann, wie z.B. eine Leuchtdiode. Hier wird eine auf einer der Leuchtdiode zugewanden Seite des wenigstens einen photonischen Kristalls 22 einfallende elektromagnetische Strahlung der Leuchtdiode 14 durch die auf den vorbestimmten Wellenlängenbereich abgestimmte dreidimensionale periodische Struktur der Filterstruktur 12 bzw. des Arrays 24 aus photonischen Kristallen 22 gefiltert, so dass auf einer der Leuchtdiode 14 abgewandten Seite 20 der Filterstruktur 12 austretende elektromagnetische Strahlung bzw. Licht nur noch Wellenlängen des vorbestimmten Wellenlängenbereichs aufweist. Auch hier wird die Lichtquelle bzw. die Leuchtdiode 14 vorzugsweise in dem Feldkonzentrationsbereich der Filterstruktur 12 angeordnet.

Sowohl bei einem Sensor als auch bei einer Strahlungsquelle ist das opto-elektronische Bauteil 14 also vorzugsweise in dem Feldkonzentrationsbereich der Filterstruktur 12 bzw. des Arrays 24 von photonischen Kristallen 22 angeordnet. Der Feldkonzentrationsbereich weist von der zweiten Seite der Filterstruktur 12 einen vorbestimmten Abstand d auf, der im Wesentlichen durch die Prozesstechnologie bestimmt wird. Gemäß Ausführungsbeispielen ist der Abstand d bei einer 0,18 µm CMOS-Prozesstechnologie kleiner als 3 µm, vorzugsweise kleiner als 2µm.

Integrierte Bauteile basierend auf photonischen Kristallen lassen sich mit CMOS-Prozessen, wie beispielsweise einem CMOS-Opto-Prozess realisieren, ohne dass zusätzliche Prozessschritte oder weitere Bearbeitungen erforderlich sind.

Ein Verfahren zum Herstellen eines integrierten Sensors auf einem Substrat umfasst gemäß Ausführungsbeispielen einen Schritt des Erzeugens eines opto-elektronischen Bauteils 14 an einer Substratoberfläche des Substrats und ein Aufbringen einer Filterstruktur 12 mit wenigstens einem photonischen Kristall auf das opto-elektronische Bauteil 14, so dass sich das opto-elektronische Bauteil 14 in einem Feldkonzentrationsbereich des wenigstens einen photonischen Kristalls befindet und von diesem vollständig bedeckt wird, wobei das Erzeugen und das Aufbringen Teile eines CMOS-Prozesses sind.

Gemäß Ausführungsbeispielen umfasst das Aufbringen des wenigstens einen photonischen Kristalls 22 ein Aufbringen eines Schichtstapels von dielektrischen Schichten und Metallschichten, wobei die Metallschichten jeweils Mikrostrukturen aufweisen, welche Abmessungen und Abstände zwischen zwei benachbarten Mikrostrukturen aufweisen, die eine Übertragung elektromagnetischer Strahlung des vordefinierten Wellenlängenbereichs durch den wenigstens einen photonischen Kristall 22 erlauben.

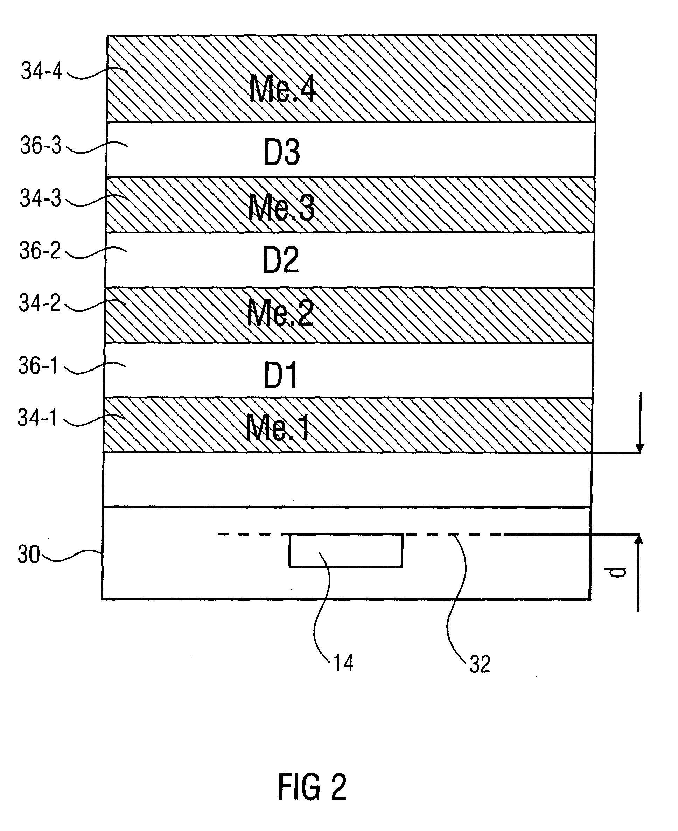

Ein Zwischenprodukt eines integrierten Sensors gemäß Ausführungsbeispielen ist schematisch in Fig. 2 gezeigt.

Der in Fig. 2 gezeigte, noch nicht fertig hergestellte, integrierte Sensor umfasst ein Substrat 30, insbesondere ein Halbleitersubstrat, indem ein opto-elektronisches Bauteil 14 eingebracht ist. Dabei ist das opto-elektronische Bauteil 14 in einer Ebene 32 angeordnet, die den Feldkonzentrationsbereich (eine Art Brennebene, die man aus der klassischen Optik kennt) der Filterstruktur 12 bzw. des Arrays 24 aus photonischen Kristallen 22 umfasst.

Die nicht fertiggestellte optische Struktur in Fig. 2 weist einen Schichtstapel aus metallischen Schichten 34 und dielektrischen Schichten 36 auf. Fig. 2 zeigt lediglich exemplarisch vier metallische Schichten 34-1 bis 34-4 und drei dielektrische Schichten 36-1 bis 36-3. Je nach Ausführungsform kann die Schichtanzahl von dem in Fig. 2 gezeigten Beispiel abweichen.

Bei aktuellen CMOS-Prozessen besteht die Möglichkeit, die Metallschichten 34-1 bis 34-4 so zu strukturieren, dass daraus resultierende Mikrostrukturen bzw. Mikroelemente periodisch angeordnet sind und Abmessungen und Abstände aufweisen, die in der Größenordnung von Wellenlängen eines vorbestimmten Wellenlängenbereichs, insbesondere eines optischen Wellenlängenbereichs, liegen. Dies ermöglicht es, dreidimensionale periodische Strukturen mit Eigenschaften von photonischen Kristallen direkt auf einem Chip zu erzeugen. Wie im Vorhergehenden bereits beschrieben wurde, sind bei Ausführungsbeispielen die einzelnen Mikroelemente bzw. Mikrostrukturen in der Größenordnung einer vorbestimmten optischen Wellenlänge, so dass ein dreidimensionaler photonischer Kristall entsteht.

Gemäß Ausführungsbeispielen wird das opto-elektronische Bauteil 14 vorzugsweise sehr nahe an der letzten Metallschicht 34-1 der Struktur platziert, wobei der Abstand d abhängig vom Herstellungsprozess ist. Der Abstand des Feldkonzentrationsbereichs von der letzten Metallschicht 34-1 der Filterstruktur 12 kann durch Abmessungen und Abstände von Strukturierungen der Metallschichten 34 eingestellt werden. Für einen integrierten optischen Sensor wird der Abstand d daher kleiner als 20 µm und bevorzugt kleiner als 8 µm gewählt. Bei 0,18 µm CMOS-Prozessen ist der Abstand zwischen dem opto-elektronischen Bauteil 14 und der Filterstruktur 12 bzw. der letzten Metallschicht 34-1 kleiner als 2 µm.

Die in Fig. 2 exemplarisch gezeigten Metallschichten 34-1 bis 34-4 werden in einem CMOS-Prozess geeignet strukturiert, um einen photonischen Kristall mit einer guten optischen Filterwirkung und evtl. sogleich fokussierender Wirkung zu erhalten, so dass keine zusätzliche Farbfilterbeschichtung benötigt wird.

Ein Bauteil 10 gemäß Ausführungsbeispielen kann also realisiert werden, indem man die vorhandenen metallischen 34 und dielektrischen Schichten 36 ausnutzt. Bei Ausführungsbeispielen ist das opto-elektronische Bauteil 14 das einzige opto-elektronische Bauteil 14, insbesondere eine Photodiode, eines integrierten Bauelements. Dabei überlappt das opto-elektronische Bauteil 14 lateral mit der Filterstruktur und ist individuell ansteuerbar.Das opto-elektronische Bauteil 14 ist gemäß Ausführungsbeispielen vorzugsweise von den strukturierten Metallschichten 34 vollständig abgedeckt.

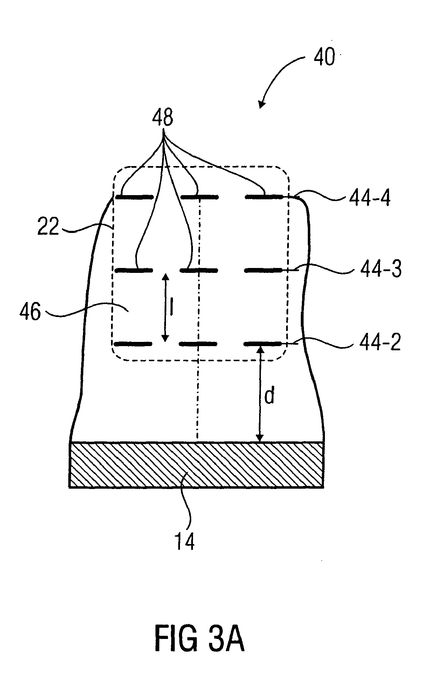

Fig. 3a zeigt eine schematische Seitenansicht eines Ausschnitts eines integrierten Bauteils 40 mit einem photonischen Kristall 22 und einem opto-elektronischen Bauteil 14.

Der in Fig. 3a gezeigte photonische Kristall 22 umfasst periodisch angeordnete strukturierte Metallschichten 44-2 bis 44-4 in einem dielektrischen Medium 46, wie z.B. SiO₂ (Siliziumdioxid). Die strukturierten Metallschichten 44 weisen Mikroelemente 48 mit Mikroöffnungen auf, so wie es in der Seitenansicht des integrierten Bauteils 40 in Fig. 3a angedeutet ist. Die geometrische Form dieser Mikroelemente 48 bzw. Mikroöffnungen kann vielfältig ausgestaltet sein und hängt von den gewünschten elektromagnetischen Eigenschaften des photonischen Kristalls 22 ab. Möglich sind beispielsweise kreisförmige Mikroöffnungen, deren Abmessungen und Abstände zueinander in der Größenordnung einer Wellenlänge des vorbestimmten Wellenlängenbereichs sind. Ein Abstand l zwischen benachbarten strukturierten Metallschichten 44 liegt ebenfalls in der Größenordnung der Wellenlänge des gewünschten Wellenlängenbereichs.

Gemäß Ausführungsbeispielen weisen die strukturierten Metallschichten 44-2 bis 44-4 des Bauteils 40, das für einen vorbestimmten Wellenlängenbereich bzw. eine Farbe selektiv ist, Mikroelemente 48 auf, deren Abstände und Abmessungen eine Größenordnung aufweisen, um beispielsweise an einer dem opto-elektronischen Bauteil 14 zugewandten Seite des photonischen Kristalls 22 eine spektrale Selektion und Konzentration des vordefinierten Wellenlängenbereichs zu bewirken. Die Abmessungen und Abstände der Mikroelemente 48 weisen gemäß Ausführungsbeispielen eine Größenordnung auf, welche in einem vordefinierten Bereich, z.B. unterhalb, um die gewünschte Wellenlänge λᵣₑₛ des vordefinierten Wellenlängenbereichs liegt. Daher werden die Mikroelemente 48 im Nachfolgenden auch als Sub-Wellenlängen-Strukturen bezeichnet. Für optische Wellenlängenbereiche weisen die Sub-Wellenlängen-Strukturen Abmessungen und Abstände zwischen zwei benachbarten Sub-Wellenlängen-Strukturen 48 auf, die im Bereich des vordefinierten Wellenlängenbereichs liegen.

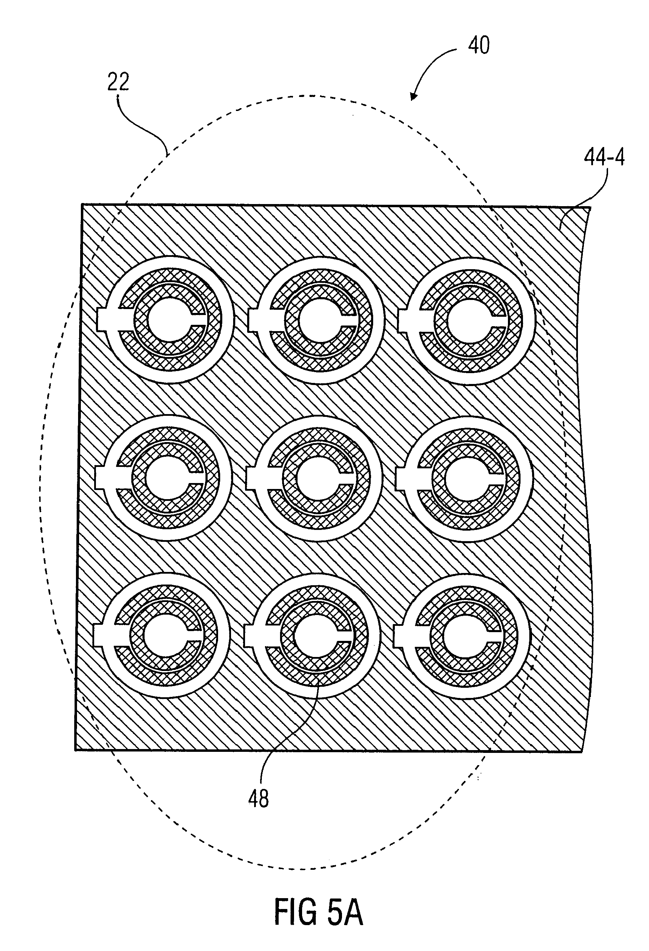

Fig. 5a zeigt eine Draufsicht auf eine mögliche Ausführungsform von den in den Metallschichten 44 realisierten Sub-Wellenlängen-Strukturen 48.

Fig. 5a kann als eine Draufsicht auf einen Ausschnitt einer strukturierten Metallschicht 44 des integrierten Bauteils 40 gesehen werden. In eine Metallschicht sind Sub-Wellenlängen-Elemente 48 angebracht. Dabei zeigt Fig. 5a exemplarisch einen Ausschnitt mit in einer 3x3-Matrix angeordneten Sub-Wellenlängen-Elementen 48, welche eine sogenannte Split-Ring-Resonator-Struktur aufweisen. Fig. 5a zeigt also eine Draufsicht einer möglichen Realisierungsform der in Fig. 3a in einer Seitenansicht gezeigten verschiedenen Metallschichten 44 mit metallischen Sub-Wellenlängen-Strukturen 48. Die Abmessungen der Sub-Wellenlängen-Strukturen 48 sind dabei vergleichbar oder kleiner als die Wellenlänge λᵣₑₛ des vordefinierten Wellenlängenbereichs. Gemäß Ausführungsbeispielen liegen die Abmessungen der Sub-Wellenlängen-Strukturen 48 in einem Bereich von beispielsweise 0.3 λᵣₑₛ bis 3λᵣₑₛ.

Ändert man das Verhältnis der Radien eines äußeren und eines inneren Kreises eines in Fig. 5a gezeigten Split-RingResonators 48, so verändert sich die entsprechende Resonator-Wellenlänge. Es sei hervorzuheben, dass auch andere Sub-Wellenlängen-Strukturen, wie beispielsweise sogenannte LC-Loaded-Transmission Lines, möglich sind, wobei wichtig ist, dass eine spektral selektive Transmission erzielt werden sollte.

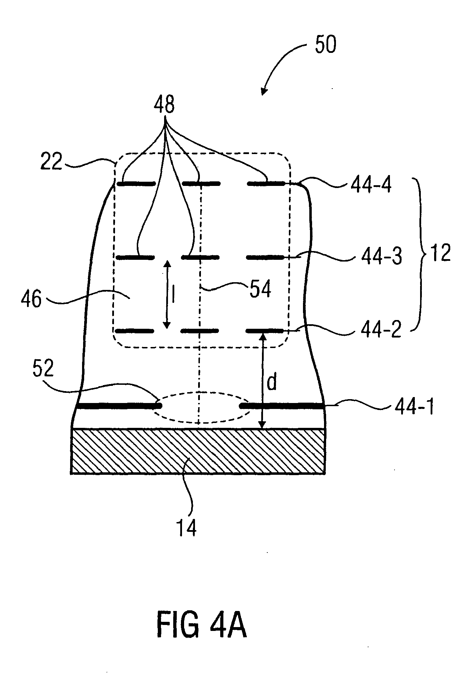

Fig. 4a zeigt einen Ausschnitt eines integriertes Bauteil 50 gemäß einem weiteren Ausführungsbeispiel der vorliegenden Erfindung.

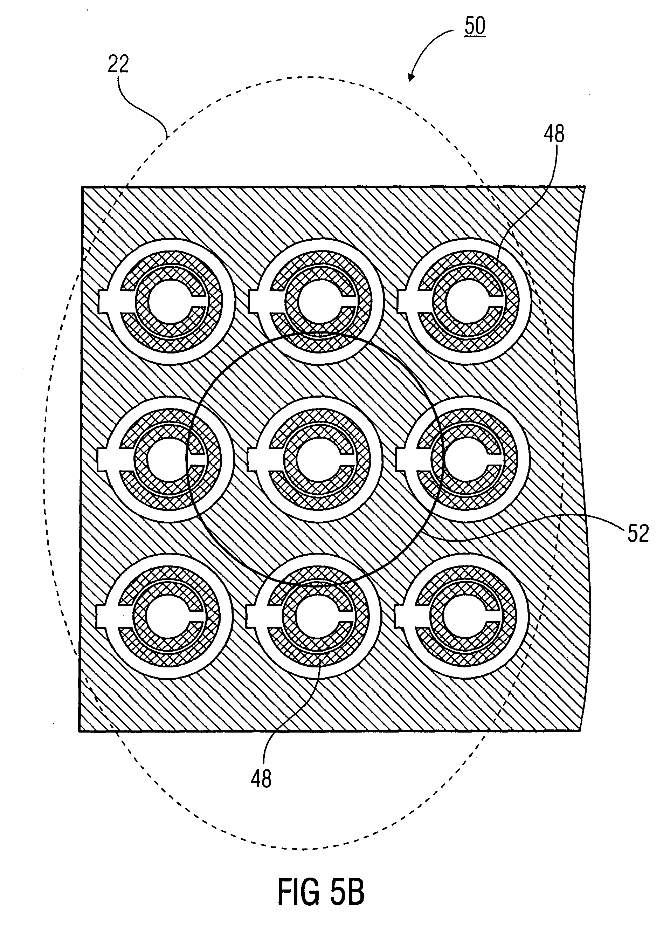

Zusätzlich zu den anhand von Fig. 3a beschriebenen strukturierten Metallschichten weist das in Fig. 4a dargestellte integrierte Sensorelement 50 zusätzlich eine Metallschicht 44-1 zwischen dem mittels der Schichten 44-2 bis 44-4 gebildeten photonischen Kristall 22 und dem opto-elektronischen Bauteil 14 auf, welche eine Öffnung 52 aufweist. Dabei ist das opto-elektronische Bauteil 14 in einem Abstand d von der untersten Metallschicht 44-2 des photonischen Kristalls beabstandet. Für einen integrierten optischen Sensor wird der Abstand d kleiner als 20 µm und bevorzugt kleiner als 8 µm gewählt. Bei 0,18 µm CMOS-Prozessen ist der Abstand d zwischen dem opto-elektronischen Bauteil 14 und untersten Metallschicht 44-2 des photonischen Kristalls kleiner als 2 µm. Auch hier sind die Sub-Wellenlängen-Elemente 48 der verschiedenen Metallschichten 44-2 bis 44-4, genau wie bei dem in Fig. 3a gezeigten Ausführungsbeispiel, jeweils exakt untereinander platziert. Ein derartiger dreidimensionaler Aufbau strukturierten Metallschichten 44-2 bis 44-4 bildet ein als Linse wirkenden photonischen Kristall. In der untersten, das heißt, dem opto-elektronischen Bauteil 14 am nächstliegenden Metallschicht 44-1, befindet sich eine Öffnung 52, so dass das Zentrum der Öffnung 52 und eine Symmetrieachse 54 des photonischen Kristalls zusammenfallen. Die aus dem photonischen Kristall 22 bestehende Filterstruktur und die Öffnung 52 befinden sich somit idealerweise auf einer gemeinsamen optischen Achse 54. Dieser Zusammenhang ist zur Veranschaulichung noch einmal in einer Draufsicht auf das Bauteil 50 in Fig. 5b gezeigt.

Die Symmetrieachse 54 des photonischen Kristalls 22 bzw. des Bauteils 50 fällt zumindest näherungsweise mit dem Mittelpunkt der Öffnung 52 zusammen. Unterhalb der Öffnung 52 in einem Abstand kleiner als d befindet sich eine optisch aktive Oberfläche des opto-elektronischen Bauteils 14, welches eine Photo- bzw. Leuchtdiode sein kann.

Die im Vorhergehenden beschriebene Filterstruktur 12 bzw. der wenigstens eine photonische Kristall 22 weist für eine bestimmte Resonanzwellenlänge λᵣₑₛ bzw. für einen vorbestimmten Resonanzwellenlängenbereich eine fokussierende Wirkung auf. Das heißt, das sich beim Auftreffen von elektromagnetischer Strahlung auf den photonischen Kristall 22 lediglich die Resonanzwellenlänge bzw. der Resonanzwellenlängenbereich ungehindert durch diesen ausbreiten kann. Durch die fokussierende Wirkung des photonischen Kristalls 22 bildet sich ein Feldkonzentrationsbereich, in dem für die Resonanzwellenlänge λᵣₑₛ bzw. den Resonanzwellenbereich eine erhöhte elektromagnetische Feldkonzentration vorherrscht. Wellenlängen außerhalb des vordefinierten Wellenlängenbereichs werden von dem photonischen Kristall 22 erst gar nicht durchgelassen bzw. sehr stark gedämpft.

Wird kollimiertes Licht verwendet, kann die Filterstruktur 12 mit dem Array 24 photonischer Kristalle 22 derart ausgebildet werden, dass sie keine nennenswerte Fokussierwirkung aufweist. D.h. die Subwellenlängenstrukturen 48 werden derart dimensioniert, dass der Feldkonzentrationsbereich quasi im Unendlichen liegt.

Bei dem im Vorhergehenden beschriebenen Ausführungsbeispielen liegt der Feldkonzentrationsbereich eines photonischen Kristalls 22 in der Nähe der Symmetrieachse 54. Wird das opto-elektronische Bauteil 14 in der Nähe dieses Feldkonzentrationsbereichs bzw. in diesem Feldkonzentrationsbereich angeordnet, so kann von dem opto-elektronischen Bauteil 14 bei Ausführungsbeispielen die Feldkonzentration der Resonanzwellenlänge λᵣₑₛ bzw. des Resonanzwellenbereichs detektiert werden.

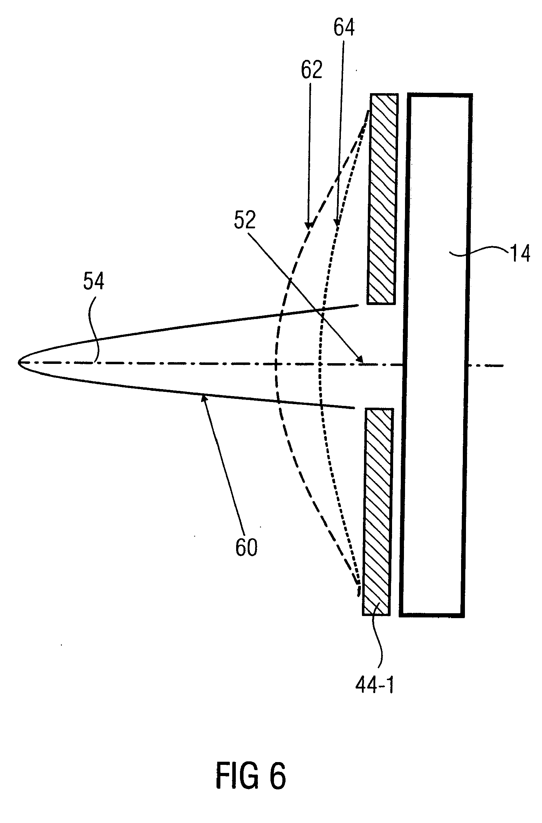

Durch die Metallschicht 44-1 mit der Öffnung 52 zwischen dem photonischen Kristall 12 und der Photodiode 14 kann eine spektrale Selektivität nochmals erhöht werden. Dieser Zusammenhang ist in Fig. 6 gezeigt.

Der Übersichtlichkeit halber zeigt Fig. 6 lediglich ein opto-elektronisches Bauteil 14 in Form einer Photodiode 14, welche hinter bzw. unter der Metallschicht 44-1 mit der Öffnung 52 angeordnet ist. Der photonische Kristall 22, der vor bzw. über der Metallschicht 44-1 angeordnet ist, ist der Übersichtlichkeit halber nicht gezeigt.

Wie im Vorhergehenden bereits beschrieben wurde, bildet sich bei Ausführungsbeispielen durch die fokussierende Wirkung des photonischen Kristalls 22 in der Nähe der Metallschicht 44-1, die der Photodiode 14 am nächsten liegt, für eine bestimmte Resonanzwellenlänge λᵣₑₛ eine Feldkonzentration aus, nicht aber für andere Wellenlängen. Das bedeutet, dass nur die elektromagnetische Strahlung der gewünschten bzw. durch die dreidimensionale periodische Struktur des photonischen Kristalls eingestellten Wellenlänge λᵣₑₛ zumindest nahezu verlustfrei auf die Photodiode 14 treffen kann, während andere Wellenlängen durch den photonischen Kristall ausgefiltert werden. D.h. der Feldkonzentrationsbereich des photonischen Kristalls 22 ist wellenlängenabhängig.

Durch die Öffnung 52 in der Metallschicht 44-1 kann die spektrale Trennung deutlich verbessert werden, so dass eine optische Kopplung zwischen der Filterstruktur und dem opto-elektonischen Bauteil 14 auf einen Filterwellenlängentransmissionsbereich begrenzt ist. In Fig. 6 sind exemplarisch drei elektromagnetische Feldverteilungen 60, 62, 64 für drei unterschiedliche Wellenlängen in der Nähe der Photodiode 14 eingezeichnet. Für die Resonanzwellenlänge λᵣₑₛ, die im Filterwellenlängentransmissionsbereich liegt, ist die Feldverteilung 60 am stärksten ausgebildet, d.h. die ganze Energie kann die Öffnung 52 passieren, während für die anderen Wellenlängen 62, 64 nur ein kleiner Anteil die Photodiode 14 erreicht.

Der photonische Kristall 22 in Form der Sub-Wellenlängen-Strukturen der oberen Metallschichten 44-2 bis 44-4 (nicht gezeigt) bewirkt zusammen mit der Öffnung 52 in der unteren Metallschicht 44-1, dass nur die vorbestimmte Wellenlänge λᵣₑₛ bzw. ein vorbestimmter Wellenlängenbereich die Photodiode 14 erreicht. Dazu befindet sich vorzugsweise das Zentrum der Öffnung 52 und das Zentrum der Sub-Wellenlängen-Strukturen 48 des photonischen Kristalls auf der Symmetrieachse 54 des photonischen Kristalls 22. Anders ausgedrückt, liegen das Zentrum der Öffnung 52 und das Zentrum der Sub-Wellenlängen-Strukturen 48 des photonischen Kristalls 22 übereinander, so dass die Sub-Wellenlängen-Strukturen und die Öffnung 52 eine gemeinsame optische Achse 54 aufweisen. Um eine Resonanz für andere Spektralbereiche zu erzielen, muss eine andere, geeignete Form für die Sub-Wellenlängen-Strukturen und ggf. die Öffnung 52 gewählt werden. Gemäß Ausführungsbeispielen weist die Öffnung 52 einen Durchmesser von ca. 1 µm auf.

An dieser Stelle soll noch einmal erwähnt werden, dass die Metallschicht 44-1 mit der Öffnung 52 nicht zwingend notwendig ist, um eine integrierte Bauteil gemäß Ausführungsbeispielen herzustellen. Jedoch umfassen bevorzugte Ausführungsformen die unterste Metallschicht 44-1 mit der Öffnung 52, da durch die sie die spektrale Selektivität der Anordnung verbessert werden kann.

Eine weitere Möglichkeit des Schichtaufbaus der strukturierten Metallschichten 44 besteht darin, statt der Lochöffnung 52 der untersten Metallschicht 44-1 eine periodische Struktur aus den gleichen oder anderen Mikroelementen 48, wie in den darüber liegenden Metallschichten 44-2 bis 44-4 auszubilden, wobei die Mikroelemente der untersten Metallschicht 44-1 aber zu denen der darüber liegenden Metallschichten lateral verschoben sind (gebrochene Symmetrie).

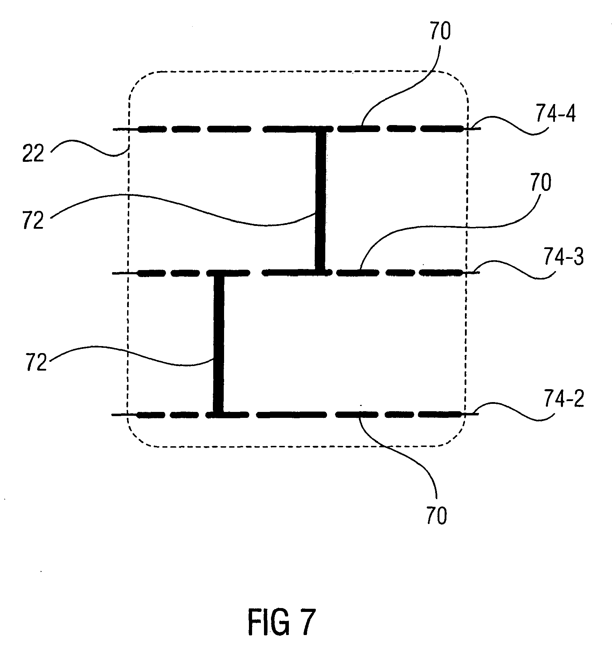

Wie im Vorhergehenden bereits erwähnt wurde, können die Mikroelemente 48 eine Vielzahl von Formen annehmen. Es sind also beispielsweise die beschriebenen sogenannten Split-Ring-Resonatoren möglich. Andere Formen sind aber ebenfalls denkbar. Die Mikroelemente 48 haben eine eigene Filterwirkung, die eine Transmission von elektromagnetischer Strahlung des photonischen Kristalls stark beeinflusst. Durch CMOS-Prozesse können nicht nur zweidimensionale, d.h. planare, sondern auch dreidimensionale Sub-Wellenlängen-Elemente 48 erzeugt werden. Dazu zeigt Fig. 7 schematisch ein Beispiel.

Fig. 7 zeigt drei strukturierte Metallschichten 74-2 bis 74-4 mit planaren Strukturen 70 und vertikalen Durchkontaktierungen 72 zwischen den strukturierten Metallschichten 74. Hier umfassen die einzelnen Sub-Wellenlängen-Elemente also planare Strukturen 70 und vertikale Strukturen 72, die zusammen dreidimensionale Sub-Wellenlängen-Elemente bilden. Die Durchkontaktierungen 72 stehen in Rahmen von herkömmlichen CMOS-Prozessen zur Verfügung. Diese dreidimensionalen Strukturen erlauben mehr Optimierungsmöglichkeiten hinsichtlich der spektralen Selektivität und der Fokussierung von elektromagnetischer Strahlung als zweidimensionale, d.h. planare Strukturen.

Lediglich exemplarisch wurde im Vorhergehenden der Aufbau von integrierten Bauelementen 10, 40, 50 anhand eines Ausschnitts mit nur einem photonischen Kristall 22 beschrieben. Die Abmessungen des Arrays 24 von photonischen Kristallen 22 sind bei Ausführungsbeispielen derart gewählt, dass der die Filterstruktur 12 bzw. der Array 24 aus photonischen Kristallen 22 eine ihm bzw. der Filterstruktur 12 zugewandte Oberfläche des opto-elektronischen Bauteils 14 vollständig abdeckt. Dazu wird ein Array 24 aus mehreren gleichartigen, d.h. auf die gleiche Wellenlänge λᵣₑₛ eingestellten, photonischen Kristallen 22 in einen Ebene über einer Photodiode platziert, um eine Photodiode vollständig abzudecken. Ein einzelner photonischer Kristall 22 kann bei dieser Anordnung als ein Arrayelement oder photonischer Sub-Kristall betrachtet werden. Im Fall einer untersten Metallschicht mit Öffnungen 52 liegen die Öffnungen 52 und die jeweiligen Zentren der Sub-Wellenlängen-Strukturen der Arrayelemente auf einer gemeinsamen optischen Symmetrieachse 54 der Arrayelemente, so wie es im Vorhergehenden bereits beschrieben wurde.

Mittels der im Vorhergehenden beschriebenen integrierten Bauteile 10, 40, 50 lassen sich gemäß Ausführungsbeispielen Farbsensoren bzw. ganze Farbsensorarrays aufbauen. Werden beispielsweise integrierte Bauelemente als Sensorelemente, welche jeweils für unterschiedliche Wellenlängen bzw. Wellenlängenbereiche selektiv sind, in einer Ebene nebeneinander angeordnet, so kann ein integrierter Farbsensor aufgebaut werden.

Für einen RGB-Farbsensor können beispielsweise für einen Bildpunkt drei integrierte Sensorelemente verwendet werden, wobei ein erstes ausgebildet ist, um auf Wellenlängen aus dem roten Spektralbereich anzusprechen, ein zweites ausgebildet ist, um auf Wellenlängen aus dem grünen Spektralbereich anzusprechen und ein drittes ausgebildet ist, um auf Wellenlängen aus dem blauen Spektralbereich anzusprechen. Das heißt, ein integrierter Farbsensor gemäß Ausführungsbeispielen umfasst eine Mehrzahl von integrierten Bauteilen mit Filterstrukturen mit wenigstens einem photonischen Kristall und Pixelsensoren bzw. Fotodioden, wie sie im Vorhergehenden beschrieben wurden, wobei die Filterstrukturen von unterschiedlichen der Mehrzahl der integrierten Bauteile ausgebildet sind, um ansprechend auf elektromagnetische Strahlung unterschiedlicher Wellenlängenbereiche jeweils an einer dem entsprechenden Pixelsensor zugewandten Seite der Filterstruktur eine elektromagnetische Feldkonzentration in der Nähe des jeweiligen Pixelsensors zu erzeugen, für die der jeweilige Pixelsensor empfindlich ist.

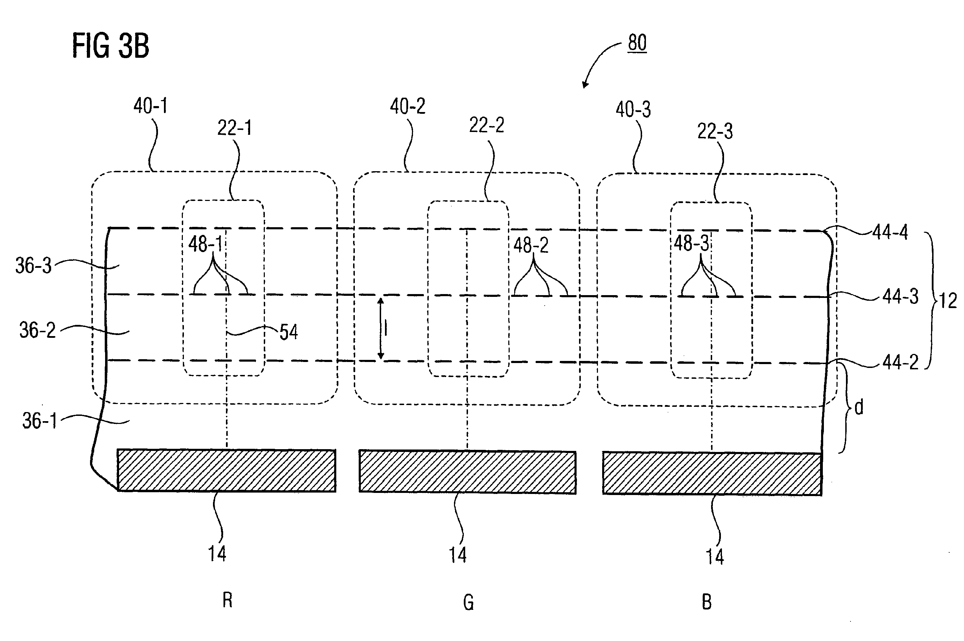

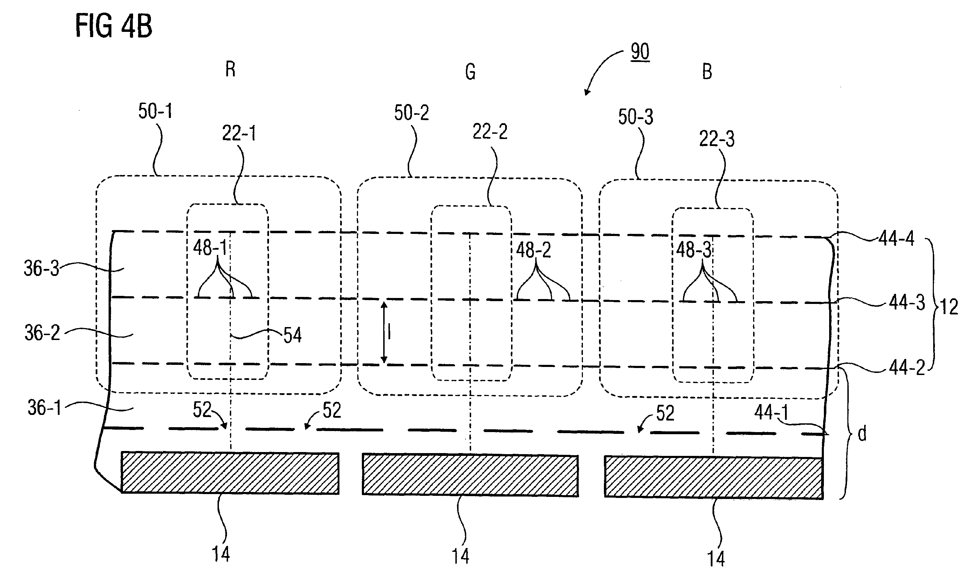

Ausführungsbeispiele für integrierte Farbsensoren mit einer Mehrzahl von integrierten Sensorelementen sind exemplarisch in den Fig. 3b und 4b gezeigt.

Fig. 3b zeigt eine Seitenansicht von drei benachbart integrierten Bauteilen 40-1 bis 40-3, die jeweils für sich eine Struktur aufweisen, wie sie im Vorhergehenden bereits anhand von Fig. 3a beschrieben wurde. Dabei ist bei dem in Fig. 3b dargestellten Farbsensor 80 zu bemerken, dass die Mikroelemente 48-1 bis 48-3 der photonischen Kristalle 22-1 bis 22-3 der drei benachbarten Sensorelemente 40-1 bis 40-3 jeweils auf unterschiedliche Wellenlängen bzw. unterschiedliche Wellenlängenbereiche eingestellt sein können, wie z.B. auf Rot, Grün und Blau.

Fig. 4b zeigt einen integrierten Farbsensorarray mit drei benachbart integrierten Sensorelementen 50-1 bis 50-3, wie sie bereits anhand von Fig. 4a ausführlich beschrieben wurden. Auch hier sind die Mikroelemente 48-1 bis 48-3 der photonischen Kristalle 22-1 bis 22-3 der jeweiligen ausgebildet, um jeweils unterschiedliche Wellenlängen (z.B. Rot, Grün, Blau) zu den jeweiligen Photodioden 14 passieren zu lassen.

Die in Fig. 3b und 4b exemplarisch gezeigten Farbsensoren können beispielsweise als Farbsensoren für einzelne Pixel eines Bildsensors verwendet werden.

Zusammenfassend umfasst die vorliegende Erfindung also ein integriertes Bauteil, welches als Sensorelement bzw. Farbsensor und/oder als Strahlungsquelle für elektromagnetische Strahlung eines vorbestimmten Wellenlängenbereichs eingesetzt werden kann. Das integrierte Bauteil kann im Rahmen von herkömmlichen CMOS-Prozessen hergestellt werden.

Die Farbe eines Objekts ist ein guter Indikator zur Qualitätskontrolle bei verschiedenen Fertigungsprozessen. Ein großes Anwendungsfeld für die vorliegende Erfindung sind beispielsweise Farbfilter, die direkt in einem Pixel eines Bildsensors integriert sind. Mikrobildsensoren mit einem bestimmten Filtereffekt (z. B. Nachbildung der Farbempfindlichkeit des Auges) sind ebenfalls interessante Anwendungsmöglichkeiten.

Mit Hilfe von Ausführungsbeispielen der vorliegenden Erfindung besteht die Möglichkeit, im Rahmen eines CMOS-Prozesses eine Photodiodenzeile zu realisieren, so dass für jede einzelne Photodiode ein entsprechender schmalbandiger Filter für einen bestimmten Spektralbereich aufgebaut wird, und sich ein Effekt wie durch ein dispersives Element (Prisma oder Gitter) in der Spektroskopie ergibt.

Abschließend ist darauf hinzuweisen, dass die vorliegende Erfindung nicht auf die jeweiligen beschriebenen Bauteile oder die erläuternden Vorgehensweisen beschränkt ist, da diese Bauteile und Verfahren variieren können. Die hier verwendeten Begriffe sind lediglich dafür bestimmt, besondere Ausführungsformen zu beschreiben und werden nicht einschränkend verwendet. Wenn in der Beschreibung und in den Ansprüchen die Anzahl oder unbestimmte Artikel verwendet werden, beziehen sich diese auch auf die Mehrzahl dieser Elemente, solange nicht der Gesamtzusammenhang eindeutlich etwas anderes deutlich macht. Dasselbe gilt in umgekehrter Richtung.

## Patentansprüche

1. Integriertes Bauelement (10;40;50) mit
einer Filterstruktur (12) mit wenigstens einem photonischen Kristall (22), der aus einem Schichtstapel aus dielektrischen Schichten (36) und einer Mehrzahl strukturierter Metallschichten (34;44) gebildet ist, wobei die strukturierten Metallschichten jeweils eine periodische Struktur aus Mikroelementen aufweisen, und wobei die Mikroelemente der strukturierten Metallschichten des wenigstens einen photonischen Kristalls (22) mit metallischen Durchkontaktierungen zumindest teilweise miteinander verbunden sind, um dreidimensionale Mikroelemente des wenigstens einen photonischen Kristalls (22) zu erhalten;
einem opto-elektronischen Bauteil (14),
wobei die Filterstruktur (12), die und das opto-elektronische Bauteil (14) gemeinsam in einem Halbleitersubstrat (16) integriert sind.

2. Integriertes Bauelement gemäß Anspruch 1, bei dem der wenigstens eine photonische Kristall (22) eine fokussierende Wirkung für elektromagnetische Strahlung eines vorbestimmten Wellenlängenbereichs aufweist, so dass die elektromagnetische Strahlung in einem Feldkonzentrationsbereich fokussiert wird, und bei dem das opto-elektronische Bauteil (14) in dem Feldkonzentrationsbereich der Filterstruktur (12) angeordnet ist.

3. Integriertes Bauelement gemäß Anspruch 1 oder 2, bei dem die Filterstruktur (12) aus einem Array (24) aus photonischen Kristallen (22) gebildet ist, um eine der Filterstruktur (12) zugewandte Oberfläche des opto-elektronischen Bauteils (14) vollständig abzudecken.

4. Integriertes Bauelement gemäß Anspruch 1 bis 3, das das opto-elektronische Bauteil (14) als das einzige opto-elektronische Bauteil (14), das lateral mit der Filterstruktur überlappt und individuell ansteuerbar ist, aufweist.

5. Integriertes Bauelement gemäß einem der vorhergehenden Ansprüche, bei dem das opto-elektronische Bauteil (14) eine Photodiode oder eine Leuchtdiode ist.

6. Integriertes Bauelement gemäß einem der vorhergehenden Ansprüche, bei dem, zusätzlich zu den strukturierten Metallschichten, die dielektrischen Schichten (36) strukturiert sind und Mikroelemente aufweisen, deren Abstände und Abmessungen eine Größenordnung aufweisen, um in der Nähe des opto-elektronischen Bauteils (14) eine spektrale Selektion zu bewirken.

7. Integriertes Bauelement gemäß einem der vorhergehenden Ansprüche, bei dem die strukturierten Metallschichten (44) Mikroelemente (48) aufweisen, deren Abstände und Abmessungen eine Größenordnung aufweisen, um in der Nähe des opto-elektronischen Bauteils (14) eine spektrale Selektion zu bewirken.

8. Integriertes Bauelement gemäß Anspruch 7, bei dem die Abmessungen und Abstände eine Größenordnung aufweisen, welche unterhalb einer Wellenlänge (λᵣₑₛ) des vordefinierten Wellenlängenbereichs liegt.

9. Integriertes Bauelement gemäß Anspruch 7 oder 8, bei dem die Größenordnung der Abmessungen und Abstände in einem Bereich zwischen 0,3λᵣₑₛ und 3λᵣₑₛ liegt.

10. Integriertes Bauelement gemäß einem der vorhergehenden Ansprüche, bei dem zwischen der dem opto-elektronischen Bauteil (14) zugewandten Seite (22) der Filterstruktur (12) und dem opto-elektronischen Bauteil (14) eine strukturierte Metallschicht (44-1) angeordnet ist.

11. Integriertes Bauelement gemäß Anspruch 10, wobei der Feldkonzentrationsbereich wellenlängenabhängig ist, so dass eine optische Kopplung zwischen der Filterstruktur und dem opto-elektonischen Bauteil auf einen Filterwellenlängentransmissionsbereich begrenzt ist und die strukturierte Metallschicht (44-1) eine Öffnung (52) aufweist, die angeordnet ist, so dass die optische Kopplung von dem Filterwellenlängentransmissionsbereich weiter eingeschränkt wird.

12. Integriertes Bauelement gemäß einem der vorhergehenden Ansprüche, bei dem das opto-elektronische Bauteil (14) von einer dem opto-elektronischen Bauteil zugewandten Seite (22) der Filterstruktur (12) einen vorbestimmten Abstand (d) aufweist, der kleiner als 20 µm und bevorzugt kleiner als 8 µm ist.

13. Integriertes Bauelement gemäß einem der vorhergehenden Ansprüche, das in CMOS-Technologie gefertigt ist.

14. Integriertes Farbarray (80; 90), mit
einer Mehrzahl von integrierten Bauelementen (40; 50) gemäß einem der vorhergehenden Ansprüche, wobei die Filterstrukturen (12) von unterschiedlichen der Mehrzahl der integrierten Bauelemente ausgebildet sind, um ansprechend auf elektromagnetische Strahlung unterschiedlicher Wellenlängenbereiche jeweils an einer dem entsprechenden opto-elektronischen Bauteil (14) zugewandten Seite der Filterstruktur eine elektromagnetische Feldkonzentration in der Nähe des jeweiligen opto-elektronischen Bauteils zu erzeugen, für die das jeweilige opto-elektronische Bauteil empfindlich ist.

15. Verfahren zum Herstellen eines integrierten Bauelements, mit folgenden Schritten:
Erzeugen eines opto-elektronischen Bauteils (14) an einer Substratoberfläche eines Substrats (30); und
Aufbringen einer Filterstruktur (12) mit wenigstens einem photonischen Kristall (22) auf das opto-elektronische Bauteil (14), wobei das Aufbringen der Filterstruktur (12) ein Aufbringen eines Schichtstapels aus wenigstens einer dielektrischen Schicht und einer Mehrzahl strukturierter Metallschichten mit Mikrostrukturen (48) umfasst, so dass die Mikroelemente der strukturierten Metallschichten des wenigstens einen photonischen Kristalls (22) mit metallischen Durchkontaktierungen zumindest teilweise miteinander verbunden sind, um dreidimensionale Mikroelemente des wenigstens einen photonischen Kristalls (22) zu erhalten,
wobei das Erzeugen und das Aufbringen Teile eines CMOS-Prozesses sind.
